# EUROPEAN PATENT SPECIFICATION

(11) **EP 0 493 824 B1**
(45) Date of publication and mention of the grant of the patent: **04.09.1996**
(21) Application number: 91122353.5
(22) Date of filing: 01.01.1992
(51) Int. Cl.: H04N 3/233

(54) **Raster distortion correction circuit**
Schaltung zur Korrektur von Rasterverzerrungen
Circuit de correction de distorsion de la trame

(30) Priority: 04.01.1991 GB 9100123
(43) Date of publication of application: 08.07.1992
(73) Proprietor: RCA Thomson Licensing Corporation, Princeton New Jersey 08540 (US)
(72) Inventor: Haferl, Peter Eduard, CH-8134 Adleswil (CH)
(74) Representative: Einsel, Robert, Dipl.-Ing.

(56) References cited:
- EP-A- 0 158 492
- EP-A- 0 236 064
- EP-A- 0 266 996
- EP-A- 0 332 091

## Description

The invention relates to a deflection circuit of a video display apparatus.

A horizontal deflection circuit is, typically, required to be accurately phased or synchronized to a video signal containing picture information for obtaining a correct raster display. In common practice, a retrace pulse produced in a flyback transformer of the deflection circuit is employed for providing a feedback pulse in a phase-controlled-loop to achieve such synchronization. However, when an ultor supply is energized by the flyback transformer, beam current variations may modulate a shape and a width of the transformer produced retrace pulse. Disadvantageously, the phase of a horizontal deflection current in a horizontal deflection winding may be offset or phase-shifted relative to that of the flyback transformer produced flyback pulse. The result may be an inaccurate synchronization causing a visible, beam current dependent, horizontal picture shift or a raster bending in a horizontal direction. This undesired effect may be further aggravated when East-West (E-W) distortion raster correction is utilized.

It may be desirable, instead of using the transformer produced retrace pulse, to use a retrace pulse developed in the horizontal deflection winding for the phasing of the deflection circuit to the video signal. To that end, it may be desirable to have an end terminal of the horizontal deflection winding at a common conductor or ground potential, during retrace.

In EP-A-0 158 492 and EP-A-0 332 091 a television deflection apparatus according to the preamble of claim 1 is disclosed.

In a horizontal deflection circuit, embodying an aspect of the invention, one end terminal of the horizontal deflection winding is coupled to ground potential. A loose coupling is provided between the flyback transformer and a retrace resonant circuit that includes the deflection winding. The grounded terminal of the deflection winding permits a more accurate phasing of the horizontal deflection winding retrace pulse to the video signal. The loose coupling reduces beam current dependent phase modulation of the horizontal deflection current and also reduces generation of so-called "mouseteeth" type raster distortion. Mouseteeth distortion is described in detail in, for example, US-A-4,634,937, entitled, EAST-WEST CORRECTION CIRCUIT, in the name of Haferl.

A television deflection apparatus according to the present invention comprises the features defined in claim 1.
FIGURE 1 illustrates a deflection circuit embodying an aspect of the invention that includes an outside pincushion correction arrangement;
FIGURES 2a-2g illustrate waveforms useful in explaining the operation of the circuit of FIGURE 1; and
FIGURE 3 illustrates a deflection circuit embodying another aspect of the invention that includes outside and inside pincushion correction arrangement.

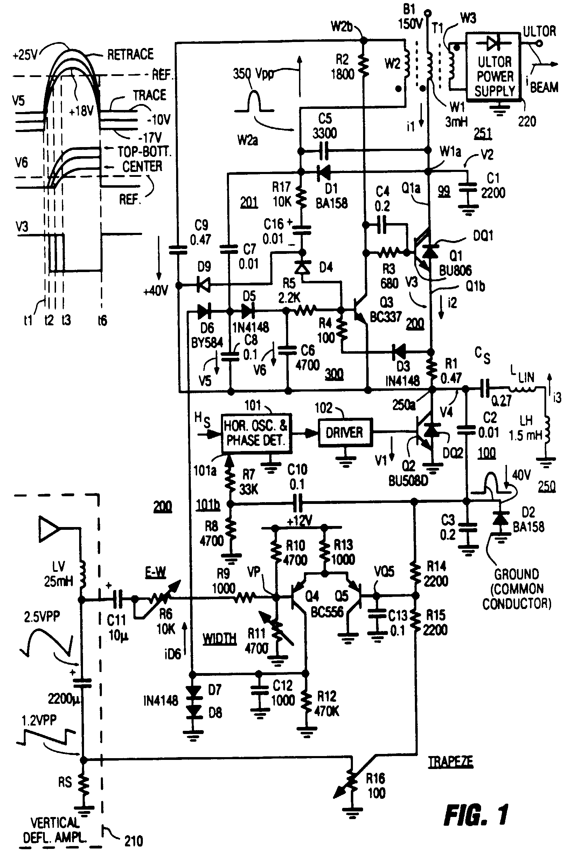

A horizontal deflection circuit 250 of FIGURE 1, embodying an aspect of the invention, provides horizontal deflection in, for example, an FS color cathode ray tube (CRT) type A66EAS00X01. Circuit 250 includes a switching transistor Q2 operating at a horizontal frequency f_{H} that is about 15.7 KHz in the NTSC standard and an anti-parallel damper diode DQ2, both being constructed as one integrated circuit. A series arrangement of retrace capacitors C2 and C3 is coupled in parallel with transistor Q2 and diode DQ2. A deflection winding L_{H} is coupled in series with an S-shaping trace capacitance Cₛ and with a linearity inductance L_{LIN}, forming a circuit branch that is coupled in parallel with each of transistor Q2, diode DQ2 and series coupled retrace capacitors C2 and C3, to form a retrace resonant circuit 100, during horizontal retrace.

A phase control stage 101 that includes a horizontal oscillator and a phase detector, not shown in detail in FIGURE 1, is responsive to a horizontal synchronizing signal Hₛ. Signal Hₛ is derived from, for example, a video detector of a television receiver, not shown in the FIGURES and is referenced to a common conductor or ground potential. Capacitors C2 and C3 form a voltage divider to obtain a sample, low amplitude retrace voltage V4a that is referenced to the common conductor or ground. Voltage V4a is applied via a coupling network 101b to a second input 101a of stage 101 to synchronize retrace pulse voltage V4 to synchronizing signal Hₛ. Stage 101 applies, via a conventional driver stage 102, a switching voltage V1 to the base-emitter junction of transistor Q2 for producing a base drive current at the horizontal frequency f_{H}. Voltage V1 is also referenced to the common conductor or ground potential.

A switched raster distortion correction circuit 200, embodying a feature of the invention, includes an E-W control circuit 300 that controls switching timing of a bipolar, switching transistor Q1 of a flyback circuit 251. A primary winding W1 of a flyback transformer T1 of circuit 251 is coupled between a source of a B+ voltage and a collector of switching transistor Q1. A flyback capacitor C1 is coupled to a junction terminal W1a, between transistor Q1 and winding W1, to form with winding W1 a flyback resonant circuit 99 of circuit 251.

In carrying out an inventive feature, a secondary winding W2 of transformer T1 is coupled at a terminal W2a to a driver stage 201 of transistor Q1 to supply power to stage 201. The emitter of transistor Q1 is coupled via a current limiting resistor R1 to the collector of transistor Q2 of circuit 250. An anti-parallel damper diode DQ1 is coupled between the collector and emitter of transistor Q1. A diode D1 having an anode that is coupled between terminal W1a of winding W2 and the collector of transistor Q1 and a cathode that is coupled to terminal W2a, together with winding W2, provides an inrush current path and over-voltage protection for E-W switching transistor Q1.

Resonant circuits 99 and 100 are parallel coupled by transistor Q1, during a controllable portion of the retrace interval to supply energy to deflection circuit 250. Resonant circuits 99 and 100 have the same resonant frequency, 44 KHz. Therefore, resonant circuits 99 and 100 can be coupled in parallel without changing the resulting resonant frequency of circuit 100.

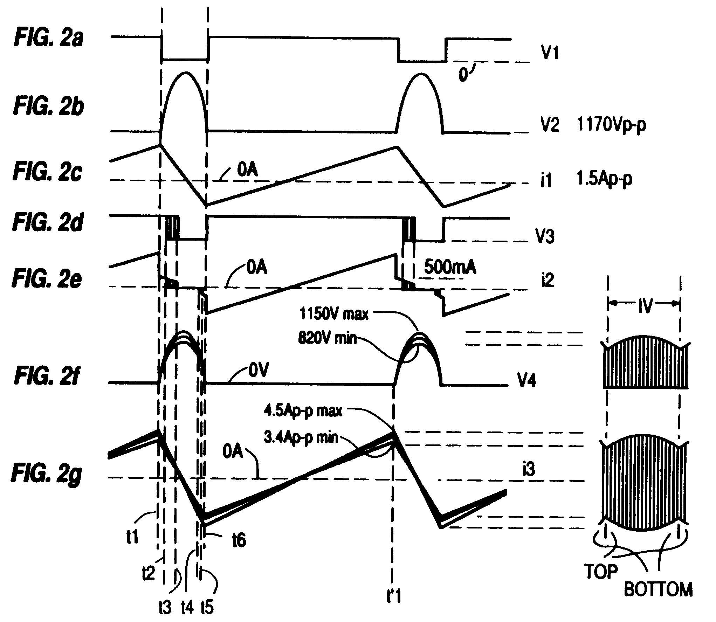

FIGURES 2a-2g illustrate waveforms useful for explaining the operation of the circuit of FIGURE 1. Similar symbols and numerals in FIGURES 1 and 2a-2g indicate similar items or functions. Transistors Q1 and Q2 of FIGURE 1 are in saturation during a trace interval, t6-t1', as illustrated by waveforms of FIGURES 2a and 2d showing drive voltages V1 and V3, respectively. An upramping trace portion of a current i1 of FIGURE 2c flows through series coupled transistors Q1 and Q2 of FIGURE 1 to ground. Deflection current i3 of FIGURE 2g flows through transistor Q2 of FIGURE 1 to ground. Negative portions of currents i1 and i3 flow through the respective integrated diodes DQ1 and DQ2 of transistors Q1 and Q2.

Deflection transistor Q2 is turned off at time t1 of FIGURE 2a to initiate a retrace interval t1-t6. Current i3 of FIGURE 1 flows then through capacitors C2 and C3 to produce retrace voltage V4, as shown in FIGURE 2f. A feedback path formed by a resistor R14 of FIGURE 1 couples voltage V4a in capacitor C3 to E-W control circuit 300. A diode D2 coupled across capacitor C3 clamps the trace portion of voltage V4a across capacitor C3 to ground potential. E-W control circuit 300 of FIGURE 1 generates a drive voltage V3 at the base of transistor Q1 to turn off transistor Q1 at a controllable instant that occurs during a portion of the retrace interval, interval t2-t3 of FIGURE 2d, as explained later on. The amplitude of retrace voltage V2 of FIGURE 2b is regulated or stabilized by supply voltage B+ and is independent of variations in the state of conduction of transistor Q1. From time t1 of FIGURE 2e until transistor Q1 is turned off, current i2 in transistor Q1 replenishes energy losses in resonant circuit 100.

Flyback current i1 is split into a first portion, current i2, of FIGURE 2e, having a small amplitude, flowing through transistor Q1 and capacitors C2 and C3. The remaining portion of current i1 flows through capacitor C1. Current i2 is modulated by the operation of transistor Q1 to obtain amplitude modulation of vertical rate, parabolic shaped envelope of retrace voltage V4 and of deflection current i3, required for correction of E-W raster distortion, as shown in the waveforms of FIGURES 2f and 2g at the right-hand side.

From top toward the center of the raster, the turn-off instant of transistor Q1 of FIGURE 1 is increasingly delayed, from time t2 to time t3 of FIGURE 2d. This causes an increasing amount of current i2 to flow into deflection circuit 250 to produce increasing amplitudes of retrace voltage V4 and of deflection current i3 of FIGURES 2f and 2g, respectively. From the center to the bottom of the raster, the turn-off instant of transistor Q1 is increasingly advanced from time t3 to time t2 of FIGURE 2d. As a result, decreasing amounts of current i2 of FIGURE 2e flow into deflection circuit 250 of FIGURE 1 causing decreasing amplitudes of voltage V4 and current i3. In this way beam positioning or pincushion distortion error is corrected.

During interval t4-t5 of FIGURE 2e, negative current i2 flows from deflection circuit 250 to flyback circuit 251. Negative current i2 is proportional to positive current i2. Energy losses in circuit 250 are replenished in accordance with the sum of the positive and negative portions of current i2. The negative portion of current i2 is produced by negative current i1. Negative current i1 supplies retrace energy that circulates into winding W1 and is important for proper operation of deflection circuit 250 and for high, or ultor voltage generation, produced via a tertiary winding W3 of transformer T1.

Control circuit 300 includes a driver transistor Q3 responsive to an E-W modulating current iD6 coupled via a diode D6 from a differential amplifier, formed by transistors Q4 and Q5. A trace voltage across winding W2 is rectified via diode DQ1 of transistor Q1 that is coupled in series with diode D1 for producing a supply voltage across a capacitor C9 of about 40 volts, required for the operation of transistors Q3 and Q1 of circuit 300.

During flyback, a flyback voltage across winding W2 is voltage divided by capacitors C7 and C8 to obtain a flyback voltage V5 in capacitor C8 of about 35 volts peak-to-peak. An upramping portion of voltage V5, shown at the left side of FIGURE 1, is used for phase modulation of a leading edge of voltage V3, during interval t2-t3, shown in the FIGURE at the left side of FIGURE 1. A diode D5 and a resistor R5 couple voltage V5 in capacitor C8 to the base of transistor Q3 for providing a base current drive and determine, in part, by way of peak voltage rectification, a DC, average value of voltage V5.

Assume, for explanation purposes, a situation in which no current flows through diode D6. It follows that diode D5 discharges capacitors C7 and C8 until voltage V5 is smaller than a minimum, threshold voltage, REF, required for turning on transistor Q3, as shown in the waveforms of FIGURE 1. As a result, transistor Q3 remains turned off throughout retrace, voltage V3 remains positive that causes transistor Q1 to be conductive throughout retrace.

Increasing charge current iD6 that flows through diode D6, produced in a manner explained later on, level-shifts the entire waveform of voltage V5 closer toward threshold voltage REF. The retrace portion of voltage V5 that exceeds or crosses threshold voltage REF, produces a current that flows through diode D5 and resistor R5. The result is that transistor Q3 is switched into saturation and produces the leading edge of voltage V3 that turns off transistor Q1 at an instant that is controlled by the magnitude of current iD6.

A capacitor C6 has a first terminal that is coupled between diode D5 and resistor R5 and a second terminal that is coupled to a collector terminal 250a of transistor Q2. During retrace, capacitor C6 charges approximately to the peak voltage of voltage V5 to supply a base drive current in transistor Q3 that keeps transistor Q3 saturated, until the end of retrace, as shown in the waveform of voltage V6 of FIGURE 1. At the end of retrace, capacitor C6 discharges via a series arrangement of resistor R5, a diode D4, a capacitor C16, a resistor R17 and winding W2, at time t6 that produces the trailing edge of voltage V3 to turn-off transistor Q3.

During retrace, capacitor C16 is charged to a negative voltage via a diode D9 and a resistor R17. During trace, it is discharged via a diode D3, a resistor R4, a diode D4 and resistor R17 for reverse biasing the base-emitter of transistor Q3. Base current of transistor Q1 is supplied via series coupled resistors R2 and R3 to keep transistor Q1 in saturation during the trace interval. Thus, the turn-off instant of transistor Q1 is modulated by the amount of charge current iD6 flowing through diode D6. A higher charge current iD6 level-shifts voltage V5 in a positive direction and causes transistor Q1 to turn-off at earlier time t2. A smaller charge current iD6 increasingly delays the turn-off instant, toward later time t3.

The differential amplifier that includes transistors Q4 and Q5 generates current iD6 to charge capacitor C8. In the amplifier, a vertical rate parabolic, E-W drive voltage VP is applied to the base of transistor Q4, produced by a vertical deflection circuit 210 in a conventional manner. A feedback portion of voltage VQ5, developed in an integrating capacitor C13 at the base of transistor Q5, is coupled via a resistor R14 and an integrating capacitor 13 from voltage V4a in capacitor C3 and is indicative of a magnitude of deflection current i3. A second portion of voltage VQ5 is developed via a resistor R15 from circuit 210 to provide trapeze correction. Charge current iD6 that varies in a vertical rate is supplied via the collector of transistor Q4 and via diode D6, only during the trace interval, when transistor Q2 is saturated and voltage V4 is zero.

Diodes D7 and D8, coupled in series, limit the voltage across a capacitor C12 coupled in parallel with a collector load resistor R12 of transistor Q4. Therefore, diodes D7 and D8 also limit voltage V5 across capacitor C8 to prevent transistor Q3 from being turned on prior to time t1, when the leading portion of voltage V2 occurs. Diode D6 is nonconductive, during retrace, to isolate the low voltage differential amplifier, formed by transistors Q4 and Q5 from retrace pulse V4 on which voltage V5 is superimposed. Thus, capacitor C8 is charged during trace for establishing the turn-off instant of transistor Q1, during retrace.

Transistors Q1 and Q2 are protected against excessive currents by resistor R1, and by a series arrangement of diode D3 and resistor R4, that is coupled between the base of transistor Q3 and a junction terminal, between resistor R1 and transistor Q1. When a voltage across current sampling resistor R1 that is coupled in series with transistors Q1 and Q2 exceeds the sum of the forward voltages of diode D3 and of the base-emitter junction of transistor Q3, transistor Q3 turns on and reduces the current flow in transistors Q1 and Q2. Deflection linearity is, advantageously, not degraded by resistor R1 because resistor R1 is outside deflection circuit 250.

Transistor Q1 operates in a common base mode during current inrush. When the B+ voltage is initially applied to the circuit, transistor Q3 is in cut off. Consequently, the base of transistor Q1 is coupled to the B+ voltage via resistors R3 and R2, winding W2, diode D1 and winding W1. When transistor Q2 starts the switching operation, transistor Q1 conducts in common base mode until a rectified trace voltage, developed across a capacitor C9, supplies sufficient base current via resistors R2 and R3 to keep transistor Q1 in saturation.

The circuit that includes diode D1, winding W2 and capacitor C9 is coupled between the collector and emitter of transistor Q1. When a flyback voltage across transistor Q1 exceeds a sum of the voltages across capacitor C9 and across winding W2, that is 350 volts, flyback current flows through diode D1, winding W2 and capacitor C9 into deflection circuit 250. This causes an increase of voltage V4 and subsequently a limitation of the collector-emitter voltage of transistor Q1 to 350 volts. Thus the E-W control range is limited by such over-voltage protection circuit. Advantageously, the over-voltage protection for transistor Q1 allows the use of a transistor with a lower voltage rating than transistor Q2.

The total flyback capacitance of flyback transformer T1 includes capacitor C1 and capacitor C7. A capacitor C5 coupled between the dotted terminals of windings W1 and W2, terminal W1a, does not contribute to the flyback time because the flyback voltage across capacitor C5 is low. It has been found, however, that capacitor C5, advantageously, reduces an output impedance of an ultor voltage supply 220, energized by winding W3, at a high beam current i_{BEAM}.

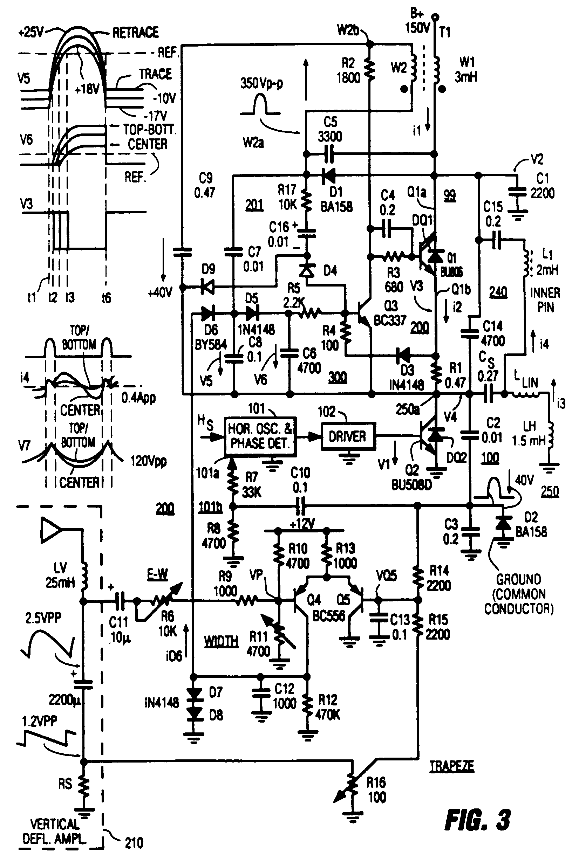

FIGURE 3 illustrates a deflection circuit embodying another aspect of the invention that is similar to that in FIGURE 1, with the differences noted below. Similar symbols and numerals in FIGURES 1, 2a-2g and 3 indicate similar items or functions.

The arrangement of FIGURE 3 provides horizontal deflection in a CRT, Philips 45AX type A66EAK00X01, which requires both outside and inside pincushion correction. An inside pincushion correction circuit 240 includes a coil L1 that may be variable for adjustment purposes, a capacitor C15 and a retrace capacitor C14. Series coupled coil L1 and capacitor C15 form an arrangement that is parallel coupled to capacitor Cₛ, during the trace interval via transistor Q1. Coil L1, capacitor Cₛ and capacitor C15 form a trace resonant circuit that is tuned to, for example, 12-14 KHz, that is higher than the trace resonance frequency, of about 6 KHz of winding L_{H} and capacitor Cₛ. Thus, a current i4 in coil L1 has a higher degree of "S" shaping than deflection current i3, as shown in the waveform of current i4 in FIGURE 3. Current i4 is generated by a voltage V7 developed across capacitor Cₛ. Current i4 is modulated by the retrace voltage across transistor Q1. This retrace voltage is the difference between voltages V2 and V4 and, therefore, is amplitude modulated by the outside pincushion circuit of FIGURE 1. Retrace voltage V4 of FIGURE 3 is of opposite phase to voltage V7, resulting in a modulation of current i4 and of voltage V7. Thus, a low flyback voltage across transistor Q1 produces an increased amplitude of each of current i4 and voltage V7 and, in turn, more "S"-shaping of deflection current i3. Similarly, less "S"-shaping is obtained at a higher amplitude of the retrace voltage across transistor Q1. Retrace capacitor C14 provides a current path for current i4 during retrace to prevent increased coupling between flyback transformer T1 and deflection circuit 250.

The circuits of FIGURES 1 and 3 may be modified for operation at a horizontal deflection frequency 2xf_{H}. In this case, an MOS transistor, instead of a bipolar transistor, may be utilized as transistor Q1. Advantageously, mooseteeth distortions are reduced in the circuits of FIGURES 1 and 3. This is so because by decoupling circuits 250 and 251 of, for example, FIGURE 1, during a significant portion of retrace, transistor Q1 reduces beam current dependent energy transfer from deflection circuit 250 back to deflection circuit 251.

In accordance with another inventive feature, transistor Q1 is coupled between resonant circuits 99 and 100 such that the collector of transistor Q1 is coupled to resonant circuit 99 via a current path section Q1a that excludes the emitter of transistor Q1; whereas the emitter of transistor Q1 is coupled to resonant circuit 100 via a current path section Q1b that excludes the collector of transistor Q1 and the common conductor. The result is that when, during retrace, transistor Q1 is nonconductive, resonant circuits 99 are decoupled from each other by transistor Q1. Therefore, advantageously, when transistor Q1 is nonconductive, resonant circuit 99 does not cause a distortion in the waveform of pulse voltage V4a in capacitor C3.

The waveform of voltage V4a in capacitor C3 is coupled to input terminal 101a of stage 101 via network 101b in a manner that bypasses transformer T1. Both capacitor C3 and stage 101 are referenced to the common conductor. Thus, by decoupling circuits 250 and 251, the waveform at terminal 101a is not distorted by beam current loading in transformer T1 and E-W modulation and, hence, more accurately represents the timings of deflection current i3 to provide more accurate phasing or synchronization in stage 101.

## Claims

1. A television deflection apparatus, comprising:
a source of a first input signal (Hs) at a frequency that is related to a first deflection frequency;
a retrace resonant circuit (100), including a deflection winding (LH) and a first retrace capacitance (C2);
a source of an input supply voltage (B+);
a supply inductance (W1) coupled to said source of input supply voltage for developing at least a portion of a flyback pulse voltage (V2) in said supply inductance;
first controllable switching means (Q2) responsive to said first input signal and coupled to said retrace resonant circuit and to said supply inductance for generating a deflection current (C3) in said deflection winding and for developing at least a portion of a first retrace pulse voltage (V4) in said retrace resonant circuit during a retrace interval of a given deflection cycle; and
a source (LV) of a modulation second input signal (VP);
characterized by:
second controllable switching means (Q1) responsive to said first and second input signals and coupled between said supply inductance and said retrace resonant circuit for decoupling said supply inductance from said retrace resonant circuit and to develop said flyback pulse voltage at a first main current conducting terminal of said second switching means and said first retrace pulse voltage at a second main current conducting terminal of said second switching means, during a controllable first portion (t3-t6) of said first retrace pulse voltage that occurs when said supply inductance and said retrace resonant circuit are decoupled, the controllable first portion of said first retrace-pulse voltage varying in accordance with said second input signal.

2. An apparatus according to Claim 1 characterized in that said first main current conducting terminal of said second switching means (Q1) is coupled to said supply inductance (W1) at a point (Wla) remote from said retrace resonant circuit (100), and said second main current conducting terminal of said second switching means is coupled to said retrace resonant circuit at a point (250a) remote from said supply inductance.

3. An apparatus according to Claim 1 characterized in that said second switching means (Q1) forms, during said first portion (t3-t6), a high impedance that is interposed between said supply inductance (W1) and said retrace resonant circuit (100).

4. An apparatus according to Claim 1 characterized by, a flyback capacitance (C1) coupled to said supply inductance (W1) to form a flyback resonant circuit (251) that is coupled via said second switching means (Q1) to said deflection winding (LH) during a second portion (t1-t3) of said first retrace pulse voltage (V4).

5. An apparatus according to Claim 4 characterized in that said resonant circuits (100, 251) have, each, substantially equal resonance frequencies.

6. An apparatus according to Claim 4 characterized in that a resonance frequency of a combined resonant circuit that includes said supply inductance (W1), said deflection winding (LH) said first retrace capacitance (C2) and said flyback capacitance (C1) is substantially the same as that of said retrace resonant circuit (100), alone.

7. An apparatus according to Claim 1 characterized in that said supply inductance (W1) comprises a primary winding of a flyback transformer (T1) having a second winding (W3) that is coupled to an ultor voltage power supply (220) that is energized by a high voltage developed in said second winding of said transformer, said ultor voltage power supply forming a load that varies in accordance with a beam current (i_{BEAM}) variation.

8. An apparatus according to Claim 1 characterized in that said second switching means (Q1) operates in a conductive state during a first portion (t3-t6) of said first retrace pulse voltage (V4) and in a nonconductive state during said first portion (t1-t3) of said first retrace pulse voltage.

9. An apparatus according to Claim 8 characterized in that said second portion (t1-t3) precedes said first portion during a given retrace interval (t1-t6).

10. An apparatus according to Claim 8 characterized in that a retrace resonance frequency of said retrace resonant circuit (100) is maintained substantially the same when said second switching means (Q1) is conductive and when said second switching means is nonconductive.

11. An apparatus according to Claim 1 characterized in that said supply inductance (W1) comprises a winding of a flyback transformer (T1) that is decoupled from said retrace resonant circuit (100) by said second switching means (Q1) when said second switching means is nonconductive and that is coupled through said second switching means to said retrace resonant circuit when said second switching means is conductive.

12. An apparatus according to Claim 1 characterized by, a phase-control-stage (101) responsive to said first input signal (Hₛ) and to a feedback retrace pulse voltage (V4a) that is coupled from said retrace resonant circuit (100) in a manner that bypasses said supply inductance (W1).

13. An apparatus according to Claim 1 characterized in that said second switching means (Q1) is coupled in series with said first switching means (Q2) during a trace portion (t6-t1') of said given deflection cycle.

14. An apparatus according to Claim 1 characterized by, a trace capacitance (Cₛ) that is coupled to said deflection winding (LH) to form a first trace resonant circuit during a trace interval (t6-t1') of said deflection cycle and a second trace resonant circuit (240, Fig. 3) that is coupled to said trace capacitance to provide an inside pincushion distortion correction.

15. An apparatus according to Claim 1 characterized in that each of said first (Q2) and second (Q1) switching means operates at a horizontal rate and wherein said second switching means becomes nonconductive, within said retrace interval, at an instant that varies at a vertical rate parabolic manner that provides pincushion distortion correction.

16. An apparatus according to Claim 1 characterized by, means (Q4, Q5) responsive to a signal at a vertical rate (VP) for producing a control signal (V3) at a control terminal (base) of said second switching means (Q1) such that a phase of said control signal varies in accordance with said vertical rate signal.

17. An apparatus according to Claim 1 characterized by, a second retrace capacitance (C3) that is coupled in series with said first retrace capacitance (C2) to develop in said second retrace capacitance a second retrace pulse voltage (V4a) and a phase-control stage (101) having an input (101a) coupled between said retrace capacitances in a manner that bypasses said supply inductance (W1).

18. An apparatus according to Claim 1 characterized by, a control circuit (200) that is referenced to a junction terminal (250a) between said first (Q2) and second (Q1) switching means for generating a control signal (V3) at a control terminal of said second switching means wherein, during a trace interval (t6-t1') of said deflection cycle, said junction terminal is at a constant potential and wherein, during said retrace interval (t1-t6), a retrace voltage (V4) is developed at said junction terminal.

19. An apparatus according to Claim 1 characterized by, a load circuit (220) coupled to said supply inductance (W1) and energized by said flyback pulse voltage (V2) wherein said second switching means (Q1) forms a high impedance that reduces mouseteeth distortions by reducing energy transfer from said retrace resonant circuit (100) to said load circuit, during said retrace interval (t1-t6).

20. An apparatus according to Claim 1 characterized by, means (101) responsive to said first input signal (Hₛ) and to said first retrace pulse voltage (V4) for generating a control signal (V1) that is coupled to a control terminal of said first switching means (Q2) to form a phase-control-loop, wherein said second switching means (Q1) decouples said flyback pulse voltage (V2) from said control signal generating means.

21. An apparatus according to Claim 20 characterized in that said first retrace pulse voltage (V4, V4a) is referenced to a reference potential (GROUND) of said control signal generating means (101).

22. An apparatus according to Claim 1 characterized in that said first (Q2) and second (Q1) switching means are coupled in series, during a portion (center of trace to t1') of a trace interval of said deflection cycle and wherein said supply inductance (W1), said second switching means (Q1) and said retrace resonant circuit (100) are coupled in series during a second portion (tl-t3) of said first retrace pulse voltage (V4).

23. An apparatus according to Claim 1 characterized in that said second switching means (Q1) decouples said first retrace pulse voltage (V4) from said supply inductance (W1) and said flyback pulse voltage (V2) from said retrace resonant circuit (100), during said controllable first portion (t3-t6) of said retrace pulse voltage.

## Revendications

1. Appareil de déviation pour télévision comprenant :
la source d'un premier signal d'entrée (Hs) à une fréquence liée à une première fréquence de déviation ;
un circuit résonant de retour de spot (100), intégrant une bobine de déviation (LH) et une première capacité de retour de spot (C2) ;
une source de tension d'alimentation d'entrée (B+) ;
une inductance d'alimentation (W1) couplée à ladite source de tension d'alimentation d'entrée afin de générer au moins une partie de la tension de l'impulsion de retour (V2) dans ladite inductance d'alimentation ;
un premier moyen de commutation contrôlable (Q2) sensible audit premier signal d'entrée, et couplé audit circuit résonant de retour de spot et à ladite inductance d'alimentation afin de générer une intensité de déviation (C3) dans ladite bobine de déviation et de développer au moins une partie d'une première tension d'impulsion de retour de spot (V4) dans ledit circuit résonant de retour de spot pendant l'intervalle de retour de spot d'un cycle de déviation donné ; et
la source (LV) d'un second signal d'entrée de modulation (VP) caractérisé par:
un second moyen de commutation contrôlable (Q1) sensible auxdits premiers et seconds signaux d'entrée et couplés entre ladite inductance d'alimentation et ledit circuit résonant de retour de spot en vue du découplage de ladite inductance d'alimentation à partir dudit circuit résonant de retour de spot et afin de développer ladite tension d'impulsion de retour au niveau d'une première borne conductrice de courant principal dudit second moyen de commutation et de ladite première tension d'impulsion de retour de spot au niveau d'une seconde borne conductrice de courant principal dudit second moyen de commutation, pendant une première partie contrôlable (t3 - t6) de ladite première tension d'impulsion de retour de spot générée lorsque ladite inductance d'alimentation et ledit circuit résonant de retour de spot sont découplés, la première partie contrôlable de ladite première tension de l'impulsion de retour de spot variant en fonction dudit second signal d'entrée.

2. Appareil conforme à la Revendication 1 caractérisé en ce que ladite première borne conductrice de courant principal dudit second moyen de commutation (Q1) est couplée à ladite inductance d'alimentation (W1) à un point (W1a) éloigné dudit circuit résonant de retour de spot (100) et en ce que ladite seconde borne conductrice de courant principal dudit second moyen de commutation est couplée audit circuit résonant de retour de spot à un point (250a) éloigné de ladite inductance d'alimentation.

3. Appareil conforme à la Revendication 1 caractérisé en ce que ledit second moyen de commutation (Q1) développe, pendant ladite première partie (t3-t6), une impédance élevée qui s'interpose entre ladite inductance d'alimentation (W1) et ledit circuit résonant de retour de spot (100).

4. Appareil conforme à la Revendication 1 caractérisé par une capacité de retour (C1) couplée à ladite inductance d'alimentation (W1) pour former un circuit résonant de retour (251) couplé par l'intermédiaire dudit second moyen de commutation (Q1) à ladite bobine de déviation (LH) pendant une seconde partie (t1-t3) de ladite première tension d'impulsion de retour de spot (V4).

5. Appareil conforme à la Revendication 4 caractérisé en ce que lesdits circuits résonants (100, 251) présentent tous des fréquences de résonance substantiellement égales.

6. Appareil conforme à la Revendication 4 caractérisé en ce que la fréquence de résonance d'un circuit résonant combiné qui intègre ladite inductance d'alimentation (W1), ladite bobine de déviation (LH) de ladite première capacité de retour de spot (C2) et ladite capacité de retour (C1), est substantiellement identique à celle dudit circuit résonant de retour de spot (100) à elle seule.

7. Appareil conforme à la Revendication 1 caractérisé en ce que ladite inductance d'alimentation (W1) intègre la bobine primaire d'un transformateur de retour (T1) qui possèdent une seconde bobine (W3) couplée à une alimentation en tension haute (220) activée par une haute tension développée dans ladite seconde bobine dudit transformateur, ladite alimentation en tension haute constituant une charge qui varie en fonction de l'intensité du faisceau (i_{BEAM}).

8. Appareil conforme à la Revendication 1 caractérisé en ce que ledit second moyen de commutation (Q1) fonctionne à l'état conducteur pendant une première partie (t3-t6) de ladite première tension d'impulsion de retour de spot (V4) et dans un état non conducteur pendant ladite première partie (t1-t3) de ladite première tension d'impulsion de retour de spot.

9. Appareil conforme à la Revendication 8 caractérisé en ce que ladite seconde partie (t1-t3) précède ladite première partie pendant un intervalle de retour de spot donné (t1-t6).

10. Appareil conforme à la Revendication 8 caractérisé en ce que la fréquence de résonance de retour de spot dudit circuit résonant de retour de spot (100) est maintenu à un niveau substantiellement égal lorsque ledit second moyen de commutation (Q1) est conducteur et que ledit second moyen de commutation n'est pas conducteur.

11. Appareil conforme à la Revendication 1 caractérisé en ce que ladite inductance d'alimentation (W1) intègre la bobine d'un transformateur de retour (T1) découplée dudit circuit résonant de retour de spot (100) par ledit moyen de commutation (Q1) lorsque ledit second moyen de commutation est non conducteur, et couplée par ledit second moyen de commutation jusqu'audit circuit résonant de retour de spot lorsque ledit second moyen de commutation est conducteur.

12. Appareil conforme à la Revendication 1 caractérisé par un étage de commande de phase (101) sensible audit premier signal d'entrée (Hₛ) et à une tension d'impulsion de retour de spot de réaction (V4a) couplée à partir dudit circuit résonant de retour de spot (100) de manière à contourner ladite inductance d'alimentation (W1).

13. Appareil conforme à la Revendication 1 caractérisé en ce que ledit second moyen de commutation (Q1) est couplé en série avec ledit premier moyen de commutation (Q2) pendant une partie de l'intervalle de balayage de lignes (t6-t1') dudit cycle de déviation donné.

14. Appareil conforme à la Revendication 1 caractérisé par une capacité de balayage de lignes (Cₛ) couplée à ladite bobine de déviation (LH) pour former un premier circuit résonant de balayage de lignes pendant un intervalle de balayage de lignes (t6-t1') dudit cycle de déviation, et un second circuit résonant de balayage de lignes (240, Fig. 3) couplé à ladite capacité de balayage de lignes pour donner une correction interne de la déformation en coussin.

15. Appareil conforme à la Revendication 1 caractérisé en ce que chaque premier (Q2) et second (Q1) moyen de commutation fonctionnent suivant le principe de retour de spot horizontal, et en ce que ledit second moyen de commutation devient non conducteur, pendant ledit intervalle de retour de spot, à un instant qui varie suivant un principe de balayage vertical suivant une manière parabolique qui assure la correction de la distorsion en coussins.

16. Appareil conforme à la Revendication 1 caractérisé par des moyens (Q4, Q5) sensibles à un signal, à un retour de balayage vertical (VP), afin de générer un signal de commande (V3) sur une borne de commande (base) dudit second moyen de commutation (Q1) de manière à ce que la phase dudit signal de commande varie en fonction dudit signal de retour vertical de balayage.

17. Appareil conforme à la Revendication 1 caractérisé par une seconde capacité de retour de spot (C3) couplée en série avec ladite première capacité de retour de spot (C2) afin de générer dans ladite seconde capacité de retour de spot, une seconde tension d'impulsion de retour de spot (V4a) et un étage de commande de phase (101) dont une entrée (101a) est couplée entre lesdites capacités de retour de spot de manière à contourner ladite inductance d'alimentation (W1).

18. Appareil conforme à la Revendication 1 caractérisé par un circuit de commande (200J) référencé jusqu'à une borne de connexion (250a) entre ledit premier (Q2) et le ledit second (Q1) moyen de commutation afin de générer un signal de commande (V3) au niveau d'une borne de commande dudit second moyen de commutation où ladite borne de connexion est, pendant un intervalle de balayage de lignes (t6-t1') dudit cycle de déviation, à un potentiel constant et où une impulsion de retour de spot (V4) est générée sur ladite borne de connexion pendant ledit intervalle de retour de spot (t1-t6).

19. Appareil conforme à la Revendication 1 caractérisé par un circuit de charge (220) couplé à ladite inductance d'alimentation (W1) et activé par ladite tension d'impulsion de retour (V2), ledit second moyen de commutation (Q1) générant une haute impédance qui réduit les distorsions en crénelures en réduisant le transfert d'énergie dudit circuit résonant de retour de spot (100) jusqu'audit circuit de charge, pendant ledit intervalle de retour de spot (t1-t6).

20. Appareil conforme à la Revendication 1 caractérisé par un moyen (101) sensible audit premier signal d'entrée (Hₛ) et à ladite première tension d'impulsion de retour de spot (V4) afin de générer un signal de commande (V1) qui est couplé à une borne de commande dudit premier moyen de commutation (Q2) afin de former une boucle de commande de phase, ledit second moyen de commutation (Q1) découplant ladite tension d'impulsions de retour (V2) à partir dudit moyen de génération de signaux de commande.

21. Appareil conforme à la Revendication 20 caractérisé en ce que ladite première tension d'impulsion de retour de spot (V4, V4a) est référencée jusqu'à un potentiel de référence (MASSE) dudit moyen à l'origine des signaux de commande (101).

22. Appareil conforme à la Revendication 1 caractérisé en ce que ledit premier (Q2) et ledit second (Q1) moyen de commutation sont couplés en série, pendant une partie (milieu de l'intervalle de retour de balayage jusqu'à t1') d'un intervalle de retour de balayage dudit cycle de déviation, et en ce que ladite inductance d'alimentation (W1), ledit second moyen de commutation (Q1) et ledit circuit résonant de retour de spot (100) sont couplés en série pendant une seconde partie (t1-t3) de ladite première tension d'impulsion de retour de spot (V4).

23. Appareil conforme à la Revendication 1 caractérisé en ce que ledit second moyen de commutation (Q1) découple ladite première tension d'impulsion de retour de spot (V4) à partir de ladite inductance d'alimentation (W1) et de ladite tension d'impulsion de retour (V2) à partir du circuit résonant de retour de spot (100) pendant ladite première partie contrôlable (t3-t6) de ladite tension d'impulsion de retour de spot.

## Patentansprüche

1. Fernseh-Ablenkschaltung umfassend:
eine Quelle für ein erstes Eingangssignal (Hs) mit einer Frequenz, die auf eine erste Ablenkfrequenz bezogen ist;
eine Rücklauf-Resonanzschaltung (100) mit einer Ablenkwicklung (LH) und einer ersten Rücklauf-Kapazität (C2);
eine Quelle für eine Eingangs-Versorgungsspannung (+B);
eine Versorgungs-Induktivität (W1), die mit der Quelle für die Eingangs-Versorgungsspannung verbunden ist, um wenigstens einen Teil einer Rücklauf-Impulsspannung (V2) in der Versorgungs-Induktivität zu erzeugen;
erste steuerbare Schaltmittel (Q2), die auf das erste Eingangssignal ansprechen und mit der Rücklauf-Resonanzschaltung und mit der Versorgungs-Induktivität verbunden sind, um in der Ablenkwicklung einen Ablenkstrom (C3) zu erzeugen, und um wenigstens einen Teil einer ersten Rücklauf-Impulsspannung (V4) in der Rücklauf-Resonanzschaltung während eines Rücklauf-Intervalls in einem gegebenen Ablenkzyklus zu erzeugen; und
eine Quelle (LV) für ein zweites Modulations-Eingangssignal (VP);
gekennzeichn et durch:
zweite steuerbare Schaltmittel (Q1), die auf das erste und zweite Eingangssignal ansprechen und zwischen der Versorgungs-Induktivität und der Rücklauf-Resonanzschaltung liegen, um die Versorgungs-Induktivität von der Rücklauf-Resonanzschaltung abzukoppeln und die Rücklauf-Impulsspannung an einem ersten hauptstromführenden Anschluß der zweiten Schaltmittel zu erzeugen, und um die erste Rücklauf-Impulsspannung an einem zweiten hauptstromführenden Anschluß der zweiten Schaltmittel während eines steuerbaren ersten Teils (t3 - t6) der ersten Rücklauf-Impulsspannung zu erzeugen, die auftritt, wenn die Versorgungs-Induktivität und die Rücklauf-Resonanzschaltung abgekoppelt sind, wobei sich der steuerbare erste Teil der ersten Rücklauf-Impulsspannung gemäß dem zweiten Eingangssignal ändert.

2. Schaltung nach Anspruch 1, dadurch gekennzeichnet, daß der erste haupt-stromführende Anschluß der zweiten Schaltmittel (Q1) mit der Versorgungs-Induktivität (W1) an einem Punkt (W19) verbunden ist, der von der Rücklauf-Resonanzschaltung (100) abgekehrt ist, und daß der zweite haupt-stromführende Anschluß der zweiten Schaltmittel mit der Rücklauf-Resonanzschaltung an einem Punkt (250a) verbunden ist, der von der Versorgungs-Induktivität abgekehrt ist.

3. Schaltung nach Anspruch 1, dadurch gekennzeichnet, daß die zweiten Schaltmittel (Q1) während des ersten Teils (t3 - t6) eine hohe Impedanz bilden, die zwischen der Versorgungs-Induktivität (W1) und der Rücklauf-Resonanzschaltung (100) eingefügt ist.

4. Schaltung nach Anspruch 1, gekennzeichnet durch eine Rücklauf-Kapazität (C1), die mit der Versorgungs-Induktivität (W1) verbunden ist, um eine Rücklauf-Resonanzschaltung (251) zu bilden, die über die zweiten Schaltmittel (Q1) mit der Ablenkwicklung (LH) während eines zweiten Teils (t1 - t3) der ersten Rücklauf-Impulsspannung (V4) verbunden ist.

5. Schaltung nach Anspruch 4, dadurch gekennzeichnet, daß die Resonanzschaltungen (100, 251) jeweils etwa gleiche Resonanzfrequenzen haben.

6. Schaltung nach Anspruch 4, dadurch gekennzeichnet, daß eine Resonanzfrequenz eine kombinierte Resonanzschaltung, die die Versorgungs-Induktivität (W1), die Ablenkwicklung (LH), die erste Rücklauf-Kapazität (C2) und die Rücklauf-Kapazität (C1) enthält, etwa die gleiche ist wie die der Rücklauf-Resonanzschaltung (100) allein.

7. Schaltung nach Anspruch 1, dadurch gekennzeichnet, daß die Versorgungs-Impedanz (W1) eine Primärwicklung eines Zeilenendtransformators (T1) umfaßt, der eine zweite Wicklung (W3) hat, die mit einer Endanodenspannungs-Stromversorgung (220) verbunden ist, die durch eine Hochspannung erregt wird, die in der zweiten Wicklung des Transformators erzeugt wird, wobei die Endanodenspannungs-Stromversorgung eine Last bildet, die sich gemäß einer Änderung des Strahlstroms (i_{BEAM}) ändert.

8. Schaltung nach Anspruch 1, dadurch gekennzeichnet, daß die zweiten Schaltmittel (Q1) während eines ersten Teils (t3 - t6) der ersten Rücklauf-Impulsspannung (V4) in einem leitenden Zustand und während des ersten Teils (T1 - T3) der ersten Rücklauf-Impulsspannung in einem nicht leitenden Zustand arbeiten.

9. Schaltung nach Anspruch 8, dadurch gekennzeichnet, daß der zweite Teil (t1 - t3) dem ersten Teil während eines gegebenen Rücklauf-Intervalls (t1 - t6) vorausgeht.

10. Schaltung nach Anspruch 8, dadurch gekennzeichnet, daß eine Rücklauf-Resonanzfrequenz der Rücklauf-Resonanzschaltung (100) etwa gleich gehalten wird, wenn die zweiten Schaltmittel (Q1) leitend sind, und wenn die zweiten Schaltmittel nicht leitend sind.

11. Schaltung nach Anspruch 1, dadurch gekennzeichnet, daß die Versorgungs-Impedanz (W1) eine Wicklung eines Zeilenendtransformators (T1) umfaßt, die von der Rücklauf-Resonanzschaltung (100) durch die zweiten Schaltmittel (Q1) abgekoppelt ist, wenn die zweiten Schaltmittel nicht leitend sind, und die durch die zweiten Schaltmittel mit der Rücklauf-Resonanzschaltung verbunden ist, wenn die zweiten Schaltmittel leitend sind.

12. Schaltung nach Anspruch 1, gekennzeichnet durch eine Phasensteuerstufe (101), die auf das erste Eingangssignal (H_{S}) und auf eine Rückkopplungs-Rücklauf-Impulsspannung (V4a) anspricht, die von der Rücklauf-Resonanzschaltung (100) in einer Weise zugeführt wird, daß die Versorgungs-Induktivität (W1) umgangen wird.

13. Schaltung nach Anspruch 1, dadurch gekennzeichnet, daß die zweiten Schaltmittel (Q1) während eines Hinlaufteils (t6 - t1') des gegebenen Ablenkzyklus in Reihe mit den ersten Schaltmitteln (Q2) geschaltet sind.

14. Schaltung nach Anspruch 1, gekennzeichnet durch eine Hinlauf-Kapazität (C_{S}), die mit der Ablenkwicklung (LH) verbunden ist, um eine erste Hinlauf-Resonanzschaltung während eines Hinlauf-Intervalls (t6 - t1') des Ablenkzyklus zu bilden, und um eine zweite Hinlauf-Resonanzschaltung (240, Fig. 3) zu bilden, die mit der Hinlauf-Kapazität verbunden ist, um eine innere Kissenverzerrungs-Korrektur vorzusehen.

15. Schaltung nach Anspruch 1, dadurch gekennzeichnet, daß die ersten (Q2) und zweiten (Q1) Schaltmittel mit einer horizontalen Rate arbeiten, und daß die zweiten Schaltmittel innerhalb des Rücklauf-Intervalls in einem Augenblick nicht leitend werden, der sich in einer vertikalfrequenten parabelförmigen Art ändert, die eine Kissenverzerrungs-Korrektur vorsieht.

16. Schaltung nach Anspruch 1, gekennzeichnet durch Mittel (Q4, Q5), die auf ein Signal mit einer vertikalen Rate (VP) ansprechen, um ein Steuersignal (V3) an einem Steueranschluß (Basis) der zweiten Schaltmittel (Q1) zu erzeugen, so daß eine Phase des Steuersignals sich gemäß dem vertikalfrequenten Signal ändert.

17. Schaltung nach Anspruch 1, gekennzeichnet durch eine zweite Rücklauf-Kapazität (C3), die in Reihe mit der ersten Rücklauf-Kapazität (C2) geschaltet ist, um in der zweiten Rücklauf-Kapazität eine zweite Rücklauf-Impulsspannung (V4a) zu erzeugen, und durch eine Phasensteuerstufe (101) mit einem Eingang (101a), der in einer Weise zwischen den Rücklauf-Kapazitäten liegt, daß die Versorgungs-Induktivität (W1) umgangen wird.

18. Schaltung nach Anspruch 1, gekennzeichnet durch eine Steuerschaltung (200), die auf einen Verbindungsanschluß (250a) zwischen den ersten (Q2) und den zweiten (Q1) Schaltmitteln bezogen ist, um ein Steuersignal (V3) an einem Steueranschluß der zeiten Schaltmittel zu erzeugen, wobei während eines Hinlauf-Intervalls (t6 - t1') des Ablenkzyklus der Verbindungsanschluß auf einem konstanten Potential liegt, und wobei während des Rücklauf-Intervalls (t1 - t6) eine Rücklauf-Spannung (V4) an dem Verbindungsanschluß erzeugt wird.

19. Schaltung nach Anspruch 1, gekennzueichnet durch eine Lastschaltung (220), die mit der Versorgungs-Induktivität (W1) verbunden ist und durch die Rücklauf-Impulsspannung (V2) gespeist wird, wobei die zweiten Schaltmittel (Q1) eine hohe Impedanz bilden, die Mäusezahn-Verzerrungen vermindert, indem der Energietransfer von der Rücklauf-Resonanzschaltung (100) zur Lastschaltung während des Rücklauf-Intervalls (t1 - t6) vermindert wird.

20. Schaltung nach Anspruch 1, gekennzeichnet durch Mittel (101), die auf das erste Eingangssignal (H_{S}) und auf die erste Rücklauf-Impulsspannung (V4) ansprechen, um ein Steuersignal (V1) zu erzeugen, das einem Steueranschluß der ersten Schaltmittel (Q2) zugeführt wird, um eine Phasenregelschleife zu bilden, wobei die zweiten Schaltmittel (Q1) die Rücklauf-Impulsspannung (V2) von den das Steuersignal erzeugenden Mitteln abkoppeln.

21. Schaltung nach Anspruch 20, dadurch gekennzeichnet, daß die erste Rücklauf-Impulsspannung (V4, V4a) auf ein Bezugspotential (Masse) der das Steuersignal erzeugenden Mittel (101) bezogen ist.

22. Schaltung nach Anspruch 1, dadurch gekennzeichnet, daß die ersten (Q2) und zweiten (Q1) Schaltmittel während eines Teils (Mitte des Hinlaufs bis t1') eines Hinlauf-Intervalls des Ablenkzyklus in Reihe geschaltet sind, und daß die Versorgungs-Induktivität (W1), die zweiten Schaltmittel (Q1) und die Rücklauf-Resonanzschaltung (100) während eines zweiten Teils (t1 - t3) der ersten Rücklauf-Impulsspannung (V4) in Reihe geschaltet sind.

23. Schaltung nach Anspruch 1, dadurch gekennzeichnet, daß die zweiten Schaltmittel (Q1) die erste Rücklauf-Impulsspannung (V4) von der Versorgungs-Induktivität (W1) und die Rücklauf-Impulsspannung (V2) von der Rücklauf-Resonanzschaltung (100) während des steuerbaren ersten Teils (t3 - t6) der Rücklauf-Impulsspannung abkoppeln.
